Europäisches Patentamt

European Patent Office

Office européen des brevets

(19)

(11) **EP 1 004 687 B1**

(12) **EUROPEAN PATENT SPECIFICATION**

(45) Date of publication and mention
of the grant of the patent:
**17.12.2003 Bulletin 2003/51**

(51) Int Cl.[7]: **C23C 14/08**, C23C 14/34

(21) Application number: **98904403.7**

(86) International application number:
**PCT/JP98/00708**

(22) Date of filing: **20.02.1998**

(87) International publication number:
**WO 98/037255 (27.08.1998 Gazette 1998/34)**

(54) **SUBSTRATE COATED WITH A TRANSPARENT CONDUCTIVE FILM and SPUTTERING TARGET FOR THE DEPOSITION OF SAID FILM**

**SUBSTRAT MIT EINEM DURCHSICHTIGEN, LEITFÄHIGEN FILM BESCHICHTET, ZERSTÄUBINGSTARGET ZUR ABSCHEIDUNG DIESES FILMS**

**SUBSTRAT REVETU d'un FILM TRANSPARENT CONDUCTEUR, CIBLE POUR METALLISATION SOUS VIDE DUDIT FILM**

(84) Designated Contracting States:
**DE FR GB**

(30) Priority: **21.02.1997 JP 3813397**

(43) Date of publication of application:
**31.05.2000 Bulletin 2000/22**

(73) Proprietor: **ASAHI GLASS COMPANY LTD.
Tokyo 100-8405 (JP)**

(72) Inventor: **MITSUI, Akira,
Asahi Glass Company Ltd.
Yokohama-shi, Kanagawa 221-0863 (JP)**

(74) Representative: **Müller-Boré & Partner
Patentanwälte
Grafinger Strasse 2
81671 München (DE)**

(56) References cited:
EP-A- 0 651 399       JP-A- 4 272 612
JP-A- 4 277 408       JP-A- 7 335 030
JP-A- 8 264 022       JP-A- 63 178 414
US-A- 5 473 456

• PATENT ABSTRACTS OF JAPAN vol. 018, no. 313 (C-1212), 15 June 1994 (1994-06-15) & JP 06 065760 A (NIPPON STEEL CORP), 8 March 1994 (1994-03-08)
• D.D. EDWARDS and T.O. MASON, "A New Transparent Conducting Oxide in the Ga2O3-In2O3-SnO2 System", APPLIED PHYSICS LETTERS (USA) AMERICAN INSTITUTE OF PHYSICS, Vol. 70, No. 13, (1997), p. 1706-1708, XP002912329

**Description**

The present invention relates to a transparent conductive film, a sputtering target and a transparent conductive film-bonded substrate.

A transparent conductive film has high visible light transmittance and high electrical conductivity simultaneously and is widely used as a transparent electrode for a display device such as a liquid crystal display device or a plasma emission device, as a transparent electrode for a solar cell, as a heat reflecting film for an automobile or building glass, as an antistatic film for CRT or as a transparent heater for various antifogging devices including refrigerating show cases.

As such a transparent conductive film, an ITO (tin-doped indium oxide) film has been mainly employed, since a low resistance film can readily be obtainable. Particularly, the ITO film is widely used as an electrode for a display device. As other films, a zinc oxide type transparent conductive film of low cost and a tin oxide type transparent conductive film of low cost having high chemical resistance, are known.

Such conventional transparent conductive film materials have problems such that with ITO, indium as its main component is expensive and constitutes a bar against cost reduction, and with the zinc oxide type transparent conductive film, the chemical resistance against an acid or alkali is poor and it is accordingly difficult to apply a zinc oxide type transparent conductive film to an industrial product such as a display device.

The tin oxide type transparent conductive film is excellent in the chemical resistance, as compared with the ITO film or the zinc oxide type transparent conductive film.

The tin oxide type film is prepared by a spray method or a CVD method as an industrial method for its production, but it is difficult to form the film to have a uniform thickness. Further, during the film formation, chorine, hydrogen chloride, etc. are formed, whereby there used to be an environmental problem due to such a waste gas (or a waste liquid). The tin oxide type transparent conductive film is useful and on the other hand has such various problems.

Further, the tin oxide type transparent conductive film is crystalline, whereby there has been a problem that the scratch resistance is poor. As a reason for such poor scratch resistance, it is considered that the film surface has fine irregularities formed during the crystal growth, which tend to cause scratching.

In general, as a method for forming a film with a large area, a sputtering method is suitable, whereby a uniform thin film can readily be obtained, and there will be little environmental pollution.

Sputtering methods may generally be classified into a radio frequency (RF) sputtering method using a high frequency power source and a direct current (DC) sputtering method using a direct current power source. The RF sputtering method is excellent in that an electrically insulating material can be used as the target, but the high frequency power source is costly, has a complex structure and is not preferred for forming a film with a large area.

In the DC sputtering method, the target material is limited to a material having good electrical conductivity, but the operation is easy as a direct current power source is used whereby the structure of the apparatus is simple. As an industrial film-forming method, the DC sputtering method is preferred. JP-A-1-97315 proposes a method for forming a tin oxide conductive film by a sputtering method, but the description is limited to a RF sputtering method, and there is no description with respect to a DC sputtering method. Further, only a film having a relatively high resistance i.e. the resistivity of the film being at least $8 \times 10^{-3}$ $\Omega$cm, is thereby obtainable.

Further, JP-A-7-335030 proposes a transparent conductive oxide comprising one member or a plurality of members selected from the group consisting of $In_2O_3$, $ZnO$, $SnO_2$ and $Ga_2O_3$. However, there is no specific description of a composite oxide containing tin oxide.

Further, JP-A-4-272612 proposes an ITO film containing gallium, but indium oxide is the main component, and tin oxide is not the main component.

It is an object of the present invention to solve the above-described problems of the prior art and to provide a tin oxide type transparent conductive film having a low resistance and high scratch resistance and a method for its production, and a sputtering target for forming the tin oxide type transparent conductive film.

The present invention provides a transparent conductive film of tin oxide type containing gallium and indium, which contains, when gallium is calculated as $Ga_2O_3$, indium is calculated as $In_2O_3$ and tin is calculated as $SnO_2$, gallium in an amount of from 0.1 to 30 mol% as calculated as $Ga_2O_3$ and indium in an amount of from 0.1 to 30 mol% as calculated as $In_2O_3$, based on the total amount of $Ga_2O_3$, $In_2O_3$ and $SnO_2$.

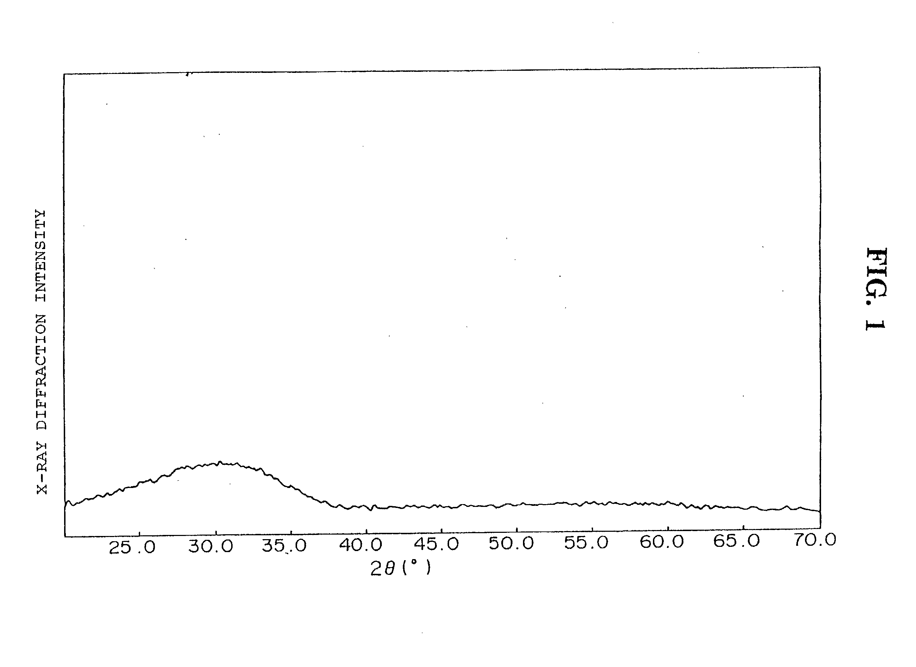

Figure 1 is an X-ray diffraction pattern of the film in Example 2 of the present invention.

With respect to the definition of the contents of gallium and indium, the same definition will apply hereinafter.

If the content of either gallium or indium is less than 0.1 mol% as calculated as the oxide, the resistivity of the film tends to be high, and the film tends to be crystalline. Further,if the content of either one is larger than 30 mol% as calculated as the oxide, the resistivity of the film tends to be high. With a view to obtaining a film having a lower electrical resistance, it is preferred that the content of gallium is from 1 to 15 mol% as calculated as $Ga_2O_3$, and the content of indium is from 1 to 15 mol% as calculated as $In_2O_3$.

Further, with a view to obtaining a film having a lower electrical resistance, it is preferred that antimony and/or tellurium is contained. When antimony is calculated as $Sb_2O_5$ and tellurium is calculated as $TeO_2$, they are preferably contained in a total amount within a range of from 0.01 to 10 mol%, based on the total amount including $Ga_2O_3$, $In_2O_3$ and $SnO_2$. If it is larger than 10 mol%, the resistance tends to be high. On the other hand, if it is less than 0.01 mol%, the effect for lowering the resistance tends to be small. With respect to the definition of the contents of antimony and/ or tellurium, the same applies hereinafter.

With a view to improving the scratch resistance, the transparent conductive film of the present invention preferably contains at least one metal (hereinafter referred to as a Group 3-5 metal) selected from the group consisting of Group 3 (inclusive of lanthanoids and not inclusive of actinoids), Group 4 and Group 5 of the long-form Periodic Table.

The Group 3-5 metal is preferably contained in the film in the form of an oxide (hereinafter referred to as a Group 3-5 metal oxide). The Group 3-5 metal oxide is preferably contained in a total amount of from 0.05 to 5 mol%, based on the total amount including $SnO_2$, $In_2O_3$ and $Ga_2O_3$. If it is less than 0.05 mol%, the effect for improving the scratch resistance tends to be small. On the other hand, if it exceeds 5 mol%, the resistivity of the film tends to be high.

Calculation of the content of the Group 3-5 metal oxide is carried out on the basis of oxides (as mentioned hereinafter) exemplified as the Group 3-5 metal oxide. With respect to the definition of the content of the Group 3-5 metal oxide, the same applies hereinafter.

As Group 3, Sc, Y and lanthanoids (La, Ce, Pr, Nd, Pm, Sm, Eu, Gd, Tb, Dy, Ho, Er, Tm, Yb and Lu) may be mentioned. Particularly, Y, La, Ce, Pr and Nd are preferred in view of the relatively low prices and high chemical resistance.

As the Group 3 metal oxide, $Sc_2O_3$, $Y_2O_3$, $La_2O_3$, $CeO_2$, $Pr_6O_{11}$, $Nd_2O_3$, $Pm_2O_3$, $Sm_2O_3$, $Eu_2O_3$, $Gd_2O_3$, $Tb_4O_7$, $Dy_2O_3$, $Ho_2O_3$, $Er_2O_3$, $Tm_2O_3$, $Yb_2O_3$ and $Lu_2O_3$ may be mentioned.

As Group 4, Ti, Zr and Hf may be mentioned. Particularly, Ti and Zr are preferred in view of the relatively low prices and high chemical resistance.

As the Group 4 metal oxide, $TiO_2$, $ZrO_2$ and $HfO_2$ may be mentioned.

As Group 5, V, Nb and Ta may be mentioned. Particularly, Nb and Ta are preferred in view of the relatively low prices and high chemical resistance.

The Group 5 oxide may be $V_2O_5$, $Nb_2O_5$ and $Ta_2O_5$.

The resistivity of the transparent conductive film of the present invention is preferably not higher than 1 Ωcm from the practical viewpoint. On the other hand, if the resistivity is too small, the film thickness required to obtain a predetermined resistance tends to be too thin, whereby it will be difficult to obtain a continuous film. Accordingly, the resistivity is preferably at least $10^{-5}$ Ωcm.

The visible light transmittance of the transparent conductive film of the present invention is preferably at least 70% from the practical viewpoint.

The present invention further provides a sputtering target of tin oxide type containing gallium and indium, which contains, when gallium is calculated as $Ga_2O_3$, indium is calculated as $In_2O_3$ and tin is calculated as $SnO_2$, gallium in an amount of from 0.1 to 30 mol% as calculated as $Ga_2O_3$ and indium in an amount of from 0.1 to 30 mol% as calculated as $In_2O_3$, based on the total amount of $Ga_2O_3$, $In_2O_3$ and $SnO_2$.

If the content of either gallium or indium is less than 0.1 mol% as calculated as the oxide, the resistivity of the formed film tends to be high, and the film tends to be crystalline. Further, if the content of either one is larger than 30 mol% as calculated as the oxide, the resistivity of the film tends to be high.

With a view to obtaining a film having a lower electrical resistance, it is preferred that the content of gallium is from 1 to 15 mol% as calculated as $Ga_2O_3$, and the content of indium is from 1 to 15 mol% as calculated as $In_2O_3$.

Further, the target of the present invention preferably contains antimony and/or tellurium, whereby a film having a lower electrical resistance can be obtained. When antimony is calculated as $Sb_2O_5$ and tellurium is calculated as $TeO_2$, they are preferably contained in a total amount within a range of from 0.01 to 10 mol%, based on the total amount of $Sb_2O_5$, $TeO_2$, $Ga_2O_3$, $In_2O_3$ and $SnO_2$. If it is larger than 10 mol%, the resistance of the target and the obtainable film tends to be high. Further, the density (high densification) of the target tends to be low, and the discharge during the sputtering tends to be instable. Further, if it is less than 0.01 mol%, the effect for reducing the electrical resistance tends to be small.

In order to make stabilized sputtering possible, the relative density of the target is preferably at least about 80%. Namely, the density of the target is preferably at least 5.5 g/cc.

Further, it is preferred that the above Group 3-5 metal is contained, since a target having a higher density can thereby be obtained. The Group 3-5 metal is preferably contained in the target in the form of an oxide (i.e. a Group 3-5 metal oxide).

Specific examples of the Group 3-5 metal and the Group 3-5 metal oxide are the same as described above.

The Group 3-5 metal oxide is preferably contained in a total amount of from 0.05 to 5 mol%, based on the total amount including $SnO_2$, $In_2O_3$ and $Ga_2O_3$. If it is less than 0.05 mol% or more than 5 mol%, the density of the target tends to be low.

In order to carry out stabilized sputtering discharge, the resistivity of the sputtering target is preferably not higher than 1 Ωcm.

Gallium in the target is preferably present in the form of an oxide or a solid solution. Here, in the form of an oxide means in the form of gallium trioxide ($Ga_2O_3$), or in the form of a composite oxide with indium oxide ($In_2O_3$) and/ or tin oxide ($SnO_2$). In the form of a solid solution means in the form of tin oxide ($SnO_2$) having gallium solid-solubilized therein and/or indium oxide ($In_2O_3$) having gallium solid-solubilized therein. It is particularly preferred that gallium is present in such a state that the major portion thereof is solid-solubilized in $SnO_2$ or $In_2O_3$.

Indium in the target is preferably present in the form of an oxide or a solid solution. Here, in the form of an oxide means in the form of $In_2O_3$ ($SnO_2$ or $Ga_2O_3$ may be solid-solubilized therein) or in the form of a complex oxide with $SnO_2$ and/or $Ga_2O_3$. In the form of a solid solution means in the form of $SnO_2$ having indium solid-solubilized therein and/or $Ga_2O_3$ having indium solid-solubilized therein. It is particularly preferred that indium is present in such a state that the major portion thereof is $In_2O_3$ ($SnO_2$ or $Ga_2O_3$ may be solid-solubilized therein) or in a state solid-solubilized in $SnO_2$.

Gallium and indium are preferably present in the form of an oxide or a solid solution, since a transparent conductive film can thereby readily be prepared. However, they may be contained in a form other than an oxide or a solid solution, such as in a form of a metal, carbide or nitride, to such an extent not to impair the purpose of the present invention.

In a case where gallium and indium in the sputtering target are present in the form of oxides, the maximum particle size of crystal particles of such oxides is preferably at most 200 μm. If oxide particles with the maximum particle size being larger than 200 μm, are present, sputtering discharge tends to be instable, such being undesirable. Further, the average particle size is preferably at least 0.01 μm from the viewpoint of handling efficiency of the powder and the moldability. Further, if the average particle size exceeds 50 μm, the sinterability tends to be poor, whereby a dense sintered body can hardly be obtained. Accordingly, the average particle size is preferably at most 50 μm.

Other components may be contained in the target of the preset invention to such an extent not to impair the purpose and the effects of the present invention, but their amount should better be as small as possible.

The composition of the film corresponds substantially to the composition of the target. However, depending upon e.g. the sputtering conditions during film-formation, the composition of the film may be different from the composition of the target.

The target of the present invention can be prepared by a common method for preparing ceramics such as an atmospheric pressure sintering method or a hot pressing method.

In the case of atmospheric pressure sintering, sintering at a high temperature will be required, and at a high temperature, the oxide is likely to be decomposed or evaporated, whereby the target tends to be hardly densified. Accordingly, it is preferred to carry out sintering in an atmosphere containing oxygen, such as air. For example, atmospheric sintering is carried out in air at a temperature of from 1300 to 1600°C.

In the case of hot pressing, sintering can be carried out at a relatively low temperature, and either an oxidizing atmosphere (an atmosphere containing an oxidizing gas) or a non-oxidizing atmosphere (an atmosphere containing no oxidizing gas) may accordingly be used. In the case of hot pressing, it is common to employ carbon as the mold material, and with a view to preventing oxidation of the mold material, it is preferred to carry out the hot pressing in a non-oxidizing atmosphere. For example, hot pressing is carried out in a non-oxidizing atmosphere at a temperature of from 800 to 1100°C.

In the case of the above-mentioned atmospheric pressure sintering in air, a target can be prepared, for example, as follows. $Ga_2O_3$ powder, $In_2O_3$ powder and $SnO_2$ powder are prepared, and these powders are mixed in a predetermined ratio. At that time, using water as a dispersing agent, mixing is carried out by a wet system ball mill method. Then, the obtained powder is dried and then filled in a rubber mold and press-molded under a pressure of 1500 kg/cm$^2$ by a cold isotropic pressing apparatus (CIP apparatus). Then, the molded product is baked at a temperature of 1500°C for 2 hours in atmospheric air to obtain a sintered body. This sintered body is machined into a predetermined size to obtain a target material. This target material is metal-bonded to a backing plate made of a metal such as copper to obtain a target.

On the other hand, in the case of the hot pressing, a target can be prepared, for example, as follows. In the same manner as in the case of the atmospheric pressure sintering, the starting material powders are mixed and dried, and then the obtained powder is filled in a hot press die made of carbon and held at a temperature of 900°C under a pressure of 300 kg/cm$^2$ for 2 hours in argon (Ar) for sintering. Thereafter, machining and metal bonding are carried out in the same manner as in the case of the atmospheric pressure sintering, to obtain a target.

The target of the present invention has high electrical conductivity, and it is sufficiently useful not only for a DC sputtering method whereby formation of a film with a large area is possible and, wherein the film forming speed is high, but also for any sputtering method such as a RF sputtering method.

Of the transparent conductive film of the present invention, the geometrical film thickness (hereinafter referred to simply as the film thickness) is preferably within a range of from 3 nm to 5 μm. If the film thickness exceeds 5 μm, the film-forming time tends to be long, whereby the cost increases. If the film thickness is thinner than 3 nm, the resistivity tends to be high. Particularly preferred is within a range of from 3 to 300 nm.

The present invention also provides a method for producing a transparent conductive film characterized by using the above-mentioned sputtering target as a sputtering target in a method for producing a transparent conductive film containing tin oxide as the main component, on a substrate by a sputtering method.

In the present invention, it is preferred to carry out sputtering in an oxidizing atmosphere. The oxidizing atmosphere is an atmosphere containing an oxidizing gas.

The oxidizing gas means an oxygen atom-containing gas such as $O_2$, $H_2O$, CO or $CO_2$. The concentration of the oxidizing gas is substantially influential over the properties of the film such as the electrical conductivity and light transmittance of the film.

Accordingly, it is necessary to optimize the concentration of the oxidizing gas depending upon the apparatus and the condition used, such as the substrate temperature and the sputtering pressure.

As the gas for sputtering, an Ar-$O_2$ system or an Ar-$CO_2$ system is preferred from a viewpoint such that the composition of the gas can easily be controlled when a transparent film having a low electrical resistance is to be prepared. Particularly preferred is an Ar-$CO_2$ system in view of the excellent controllability.

In the Ar-$O_2$ gas system, the $O_2$ concentration is preferably from 5 to 25 vol%, as a transparent film having a low electrical resistance can thereby be obtained. If it is less than 5 vol%, the film tends to be colored yellow, and the resistance of the film tends to be high. If it exceeds 25 vol%, the resistance of the film tends to be high.

Further, in the Ar-$CO_2$ gas system, the $CO_2$ concentration is preferably from 10 to 50 vol%, as a transparent film having a low electrical resistance can thereby be obtained. If it is less than 10 vol%, the film tends to be colored yellow, and the resistance of the film tends to be high. If it exceeds 50 vol%, the resistance of the film tends to be high.

However, depending upon the particular application, a colored film or high electrical resistance may be required, and accordingly, the respective concentrations may not be limited to the above-mentioned concentrations.

As the sputtering method, any sputtering method such as a DC sputtering method or a RF sputtering method may be employed. Particularly preferred is a DC-sputtering method which is excellent in the industrial productivity.

The transparent conductive film of the present invention can be prepared as follows. Using a magnetron DC sputtering and employing the above-mentioned target, the chamber is evacuated to from $10^{-7}$ to $10^{-4}$ Torr. If the pressure in the chamber is higher than $10^{-4}$ Torr, the electrical resistance tends to be hardly controllable under an influence of the moisture remaining in the evacuated chamber. If the pressure in the chamber is lower than $10^{-7}$ Torr, it takes a long time for evacuation, whereby the productivity tends to be poor. The power density (the value obtained by dividing the input power by the area of the target surface) during the sputtering, is preferably from 1 to 10 W/cm$^2$. If it is less than 1 W/cm$^2$, the electrical discharge tends to be instable. If it exceeds 10 W/cm$^2$, the target is likely to break due to the generated heat.

The sputtering pressure is preferably from $10^{-4}$ to $10^{-1}$ Torr. If it is lower than $10^{-4}$ Torr or higher than $10^{-1}$ Torr, the electrical discharge tends to be instable.

As the substrate to be used for the film formation, glass, ceramics, plastics or metals may, for example, be mentioned. The substrate temperature during the film formation is not particularly limited, but it is preferably not higher than 300°C so that an amorphous film can readily be obtained.

Further, the substrate temperature may be at a level of room temperature in a case where no intentional heating is carried out.

Further, after the film formation, the substrate may be subjected to post heating (heat treatment). The heat treatment is preferably carried out in atmospheric air from 60 to 400°C. If it is lower than 60°C, the effect for lowering the electrical resistance and imparting the

Table 1

| Examples | Target composition | | | | Target density (g/cc) | Target resistivity ($\Omega$ cm) |
|---|---|---|---|---|---|---|
| | $Ga_2O_3$ (mol%) | $In_2O_3$ (mol%) | $SnO_2$ (mol%) | Additive | | |
| 1 | 0.5 | 5 | 94.5 | — | 6.0 | $4 \times 10^{-1}$ |
| 2 | 5 | 5 | 90 | — | 6.5 | $5 \times 10^{-3}$ |
| 3 | 10 | 5 | 85 | — | 6.7 | $5 \times 10^{-3}$ |
| 4 | 20 | 5 | 75 | — | 6.7 | $4 \times 10^{-1}$ |
| 5 | 30 | 5 | 65 | — | 6.5 | $8 \times 10^{-1}$ |
| 6 | 0.5 | 10 | 89.5 | — | 5.8 | $3 \times 10^{-1}$ |
| 7 | 5 | 10 | 85 | — | 6.2 | $5 \times 10^{-3}$ |

Table 1   (continued)

| Examples | Target composition | | | | Target density (g/cc) | Target resistivity ($\Omega$ cm) |
|---|---|---|---|---|---|---|
| | $Ga_2O_3$ (mol%) | $In_2O_3$(mol%) | $SnO_2$ (mol%) | Additive | | |
| 8 | 10 | 10 | 80 | — | 6.2 | $5 \times 10^{-3}$ |
| 9 | 20 | 10 | 70 | — | 6.1 | $5 \times 10^{-2}$ |
| 10 | 30 | 10 | 60 | — | 5.9 | $1 \times 10^{-1}$ |
| 11 | 0.5 | 25 | 74.5 | — | 5.7 | $3 \times 10^{-2}$ |
| 12 | 5 | 25 | 70 | — | 5.9 | $6 \times 10^{-3}$ |
| 13 | 10 | 25 | 65 | — | 6.0 | $6 \times 10^{-3}$ |
| 14 | 20 | 25 | 55 | — | 6.2 | $6 \times 10^{-3}$ |
| 15 | 30 | 25 | 45 | — | 6.3 | $6 \times 10^{-3}$ |
| 16 | 5 | 5 | 89 | $Sb_2O_5$:1 mol% | 6.2 | $3 \times 10^{-3}$ |
| 17 | 5 | 10 | 84 | $Sb_2O_5$:1 mol% | 6.0 | $3 \times 10^{-3}$ |
| 18 | 5 | 5 | 89 | $TeO_2$:1 mol% | 6.1 | $4 \times 10^{-3}$ |
| 19 | 5 | 10 | 84 | $TeO_2$:1 mol% | 5.9 | $4 \times 10^{-3}$ |
| 20 | 5 | 5 | 89. 4 | $Y_2O_3$:0.6mol% | 6.8 | $7 \times 10^{-3}$ |
| 21 | 5 | 5 | 89.5 | $La_2O_3$: 0.5mol% | 6.8 | $8 \times 10^{-3}$ |
| 22 | 5 | 5 | 89.1 | $CeO_2$: 0.9mol% | 6.8 | $8 \times 10^{-3}$ |
| 23 | 5 | 5 | 89.9 | $Pr_6O_{11}$: 0.1mol% | 6.8 | $7 \times 10^{-3}$ |
| 24 | 5 | 5 | 89.6 | $Nd_2O_3$: 0.4mol% | 6.8 | $7 \times 10^{-3}$ |
| 25 | 5 | 5 | 88.1 | $TiO_2$:1.9mol% | 6.8 | $8 \times 10^{-3}$ |
| 26 | 5 | 5 | 88.9 | $Nb_2O_5$: 1.1mol% | 6.8 | $8 \times 10^{-3}$ |
| 27 | 4 | 87 | 9 | — | 6.8 | $2 \times 10^{-3}$ |
| 28 | 30 | 61 | 9 | — | 5.8 | $5 \times 10^{-3}$ |
| 29 | 0 | 54 | 46 | — | 4.1 | Insulating |

Table 2

| Example | Film composition | | | Film resis-tivity | Visible light transmit-ance of the film | Change in resistance (%) | | | | MR* 40℃、90%RH |
|---|---|---|---|---|---|---|---|---|---|---|
| | $Ga_2O_3$ (mol%) | $In_2O_3$ (mol%) | Additive | ($\Omega$ cm) | (%) | 5wt%HCl 25℃、2 hrs | 5wt%$H_2SO_4$ 25℃、2 hrs | 5wt%NaOH 80℃、30 min | 2wt%HF+ 2wt%$HNO_3$ 25℃、30 min | 1500 hrs |
| 1 | 0.5 | 5.1 | — | $3 \times 10^{-2}$ | 82 | 0 | 0 | 3 | 0 | -1 |
| 2 | 5.1 | 5.0 | — | $2 \times 10^{-3}$ | 82 | 0 | 0 | 2 | 0 | -1 |
| 3 | 10.1 | 4.9 | — | $3 \times 10^{-3}$ | 82 | 0 | 0 | 2 | 0 | -1 |
| 4 | 20.0 | 5.1 | — | $4 \times 10^{-2}$ | 82 | 0 | 0 | 3 | 0 | 0 |
| 5 | 30.2 | 5.2 | — | $4 \times 10^{-1}$ | 82 | 0 | 0 | 4 | 0 | 1 |
| 6 | 0.5 | 10.0 | — | $3 \times 10^{-2}$ | 82 | 0 | 0 | 3 | 0 | 0 |
| 7 | 4.9 | 10.2 | — | $2 \times 10^{-3}$ | 82 | 0 | 0 | 2 | 0 | 1 |
| 8 | 10.2 | 9.9 | — | $3 \times 10^{-3}$ | 82 | 0 | 0 | 2 | 0 | -1 |
| 9 | 19.9 | 9.9 | — | $2 \times 10^{-2}$ | 82 | 0 | 0 | 3 | 0 | 0 |
| 10 | 29.9 | 10.1 | — | $6 \times 10^{-2}$ | 82 | 0 | 0 | 4 | 0 | 0 |
| 11 | 0.5 | 25.0 | — | $1 \times 10^{-2}$ | 82 | 0 | 0 | 3 | 0 | 0 |
| 12 | 5.0 | 24.9 | — | $4 \times 10^{-3}$ | 82 | 0 | 0 | 3 | 0 | 0 |
| 13 | 9.9 | 25.1 | — | $4 \times 10^{-3}$ | 82 | 0 | 0 | 3 | 0 | 1 |
| 14 | 20.1 | 25.1 | — | $4 \times 10^{-3}$ | 82 | 0 | 0 | 4 | 0 | 1 |
| 15 | 29.8 | 25.0 | — | $4 \times 10^{-3}$ | 82 | 0 | 0 | 5 | 0 | 2 |
| 16 | 5.0 | 4.9 | $Sb_2O_5$:0.1mol% | $1 \times 10^{-3}$ | 82 | 0 | 0 | 2 | 0 | -1 |
| 17 | 4.9 | 10.1 | $Sb_2O_5$:0.1mol% | $1 \times 10^{-3}$ | 82 | 0 | 0 | 2 | 0 | 0 |
| 18 | 5.0 | 4.9 | $TeO_2$:0.2mol% | $1 \times 10^{-3}$ | 82 | 0 | 0 | 2 | 0 | -1 |
| 19 | 5.0 | 9.9 | $TeO_2$:0.2mol% | $1 \times 10^{-3}$ | 82 | 0 | 0 | 2 | 0 | 1 |
| 20 | 5.0 | 4.9 | $Y_2O_3$:0.6mol% | $5 \times 10^{-3}$ | 82 | 0 | 0 | 2 | 0 | 2 |
| 21 | 5.0 | 4.9 | $La_2O_3$:0.5mol% | $5 \times 10^{-3}$ | 82 | 0 | 0 | 2 | 0 | 1 |
| 22 | 5.0 | 4.9 | $CeO_2$:0.9mol% | $6 \times 10^{-3}$ | 82 | 0 | 0 | 2 | 0 | 0 |
| 23 | 5.0 | 4.9 | $Pr_6O_{11}$:0.1mol% | $4 \times 10^{-3}$ | 82 | 0 | 0 | 2 | 0 | 1 |
| 24 | 5.0 | 4.9 | $Nd_2O_3$:0.4mol% | $4 \times 10^{-3}$ | 82 | 0 | 0 | 2 | 0 | -1 |
| 25 | 5.0 | 4.9 | $TiO_2$:1.9mol% | $6 \times 10^{-3}$ | 82 | 0 | 0 | 2 | 0 | -2 |
| 26 | 5.0 | 4.9 | $Nb_2O_5$:1.1mol% | $5 \times 10^{-3}$ | 82 | 0 | 0 | 2 | 0 | -1 |
| 27 | 4.0 | 87.0 | — | $4 \times 10^{-4}$ | 82 | 0 | 0 | 45 | Dissolved | -1 |
| 28 | 30.0 | 61.0 | — | $9 \times 10^{-4}$ | 82 | 20 | 10 | 70 | Dissolved | 10 |
| 29 | 0.0 | 54.0 | — | $1 \times 10^{-1}$ | 82 | 0 | 0 | 4 | 0 | 2 |

MR*:  Moisture resistance

stability in resistance by the heat treatment tends to be small. If it is higher than 400°C, the resistance tends to be inversely high.

Further, the heat treatment can also be carried out in a non-oxidizing atmosphere (such as Ar or nitrogen). The temperature at that time is preferably from 60 to 600°C. If it is lower than 60°C, the effect for lowering the electrical resistance and imparting the stability in resistance by the heat treatment, tends to be small. If it is higher than 600°C, the film tends to be reduced and colored.

In order to obtain high scratch resistance, the film is preferably amorphous. However, even in a case where the film is crystallized to some extent, the bond strength of the crystal boundaries of the transparent conductive film of the present invention is high, whereby high scratch resistance can be obtained.

Further, the transparent conductive film of the present invention is excellent in acid resistance and alkali resistance, and it will scarcely be eroded even by a strong acid or by a strong alkali and will undergo no substantial change in the film resistance. Further, it will scarcely be eroded also by a hydrofluoric acid (HF) aqueous solution and will undergo no substantial change in the film resistance. Further, it has similarly high corrosion resistance also against a fluoride gas such as $CF_4$.

The present invention provides a transparent conductive film-bonded substrate characterized in that a transparent conductive film of tin oxide type containing gallium and indium, is formed on a substrate. This transparent conductive film-bonded substrate is useful as a transparent surface heater or as an antistatic article. Further, it is useful for an antistatic wafertransporting chuck for producing semiconductors.

The transparent surface heater can be obtained also by directly coating the transparent conductive film of the present invention on glass or on a plastic film. The film thickness is preferably from 10 to 300 nm from the viewpoint of the resistance value.

The antistatic article can be obtained also by directly coating the transparent conductive film of the present invention on glass or on a plastic film. The film thickness is preferably from 3 to 100 nm from the viewpoint of the resistance value.

Further, the antistatic wafer transporting chuck for production of semiconductors, can be obtained also by directly coating the transparent conductive film of the present invention on a ceramic chuck. The film thickness is preferably from 3 to 300 nm from the viewpoint of the resistance value.

In the transparent conductive film-bonded substrate of the present invention, at least one layer of undercoat film may be provided between the transparent conductive film and the substrate for the purpose of adjusting the outer appearance. Otherwise, at least one layer of overcoat film may be provided on the transparent conductive film to adjust the transmitted or reflected color or the visible light reflectance by utilizing the interference phenomenon of light or the absorption phenomenon of the film. As the undercoat or overcoat, a film of an oxide, a nitride or an oxynitride may be employed.

For example, a $SiO_x$ film, a $SiN_x$ film or a $SiO_xN_y$ film is preferred, since it is thereby possible to effectively prevent diffusion of the moisture and oxygen in air to the transparent conductive film of the present invention, or to effectively prevent diffusion of alkali ions such as sodium in the substrate glass to the transparent conductive film of the present invention.

When a target is prepared, gallium oxide and indium oxide will act as assisting agents to accelerate sintering when tin oxide as the main component is sintered. At that time, gallium oxide and indium oxide will strengthen the mutual actions. Further, gallium oxide and indium oxide will act also as additives to impart electrical conductivity to the target. Also in this case, gallium oxide and indium oxide will strengthen the mutual actions to lower the electrical resistance more efficiently.

Further, also in the transparent conductive film of the present invention, gallium oxide and indium oxide will act as additives to impart electrical conductivity to the film, in the same manner as for the target. Also in this case, gallium oxide and indium oxide will strengthen the mutual actions to lower the electrical resistance more efficiently. Further, gallium oxide and indium oxide will act to make the film amorphous by the impurity effect.

Further, antimony and tellurium will act to increase carrier electrons in the transparent conductive film and the target of the present invention and will lower the electrical resistance of the transparent conductive film and the target of the present invention.

Further, an oxide of a Group 3a element, Group 4a element and a Group 5a element will act as a sintering assistant. Further, it has an activity to strengthen the bond, and accordingly, it will act to increase the scratch resistance in the transparent conductive film of the present invention.

In the following, Examples 1 to 26 and Examples 30 and 31 correspond to Working Examples, and Examples 27 to 29 correspond to Comparative Examples.

EXAMPLES 1 to 15

$Ga_2O_3$ powder, $In_2O_3$ powder and $SnO_2$ powder were prepared, and these powders were mixed in the proportions as identified in Table 1 in a dry system ball mill. The target composition shown in Table 1 was calculated from the weighed values of the respective starting material powders. Further, the composition of a sintered body was measured by an ICP method (inductively coupled plasma emission spectrometry) and was confirmed to agree with the composition calculated from the weighed values of the starting material powders. The same applies hereinafter.

The average particle sizes of the powders used were 2.0 $\mu$m, 0.8 $\mu$m and 1.0 $\mu$m with respect to the $Ga_2O_3$ powder, the $In_2O_3$ powder and the $SnO_2$ powder, respectively. These average particles sizes were measured by a microtrack particle size measuring apparatus manufactured by Nikkiso K.K.

The mixed powder was packed into a rubber mold and press-molded by a CIP apparatus, and thereafter, baked in air at a temperature of 1500°C under atmospheric pressure for a retention time of 2 hours. The density and the resistivity of this sintered body are shown in Table 1. The density was measured by an Archimedes method. The resistivity was measured by a four terminal method with respect to a prismatic sample of $3\times3\times30$ mm which was cut out.

Then, the above sintered body was cut out in a size of 6 inches in diameter and 5 mm in thickness to obtain a target (hereinafter referred to as a GIT target).

Employing various such GIT targets and using a magnetron DC sputtering apparatus, film formation of $Ga_2O_3$-$In_2O_3$-$SnO_2$ type transparent conductive films (hereinafter referred to as GIT films) was carried out under such conditions that input power: 500 W, introduced gas: Ar-$CO_2$ mixed gas (30 vol% of $CO_2$, when Ar+$CO_2$ was 100 vol%, the total flow rate was 50 sccm), pressure: $4\times10^{-3}$ Torr, and substrate temperature: no heating. As the substrate, a soda lime glass substrate (hereinafter referred to simply as a glass substrate) was employed. The operation was carried out so that the film thickness would be about 100 nm.

In Examples 1 to 15, the optimum value for the $CO_2$ concentration was from 10 to 50 vol% (the proportion of $CO_2$ based on the total of Ar and $CO_2$ as introduced gas) by preliminary experiments. Further, in Examples 1 to 15 in Table 2, the test results in the case of $CO_2$: 30 vol% as a representative value, were shown. The resistivities and the transmittances of the respective GIT films thereby obtained, are shown in Table 2.

The film composition in Figure 2 was measured by an ICP method. The composition of the target and the composition of the GIT film substantially agreed to each other.

Identification of the film was carried out by an X-ray diffractometry. In all of Examples 1 to 15, X-ray diffraction patterns were flat and amorphous. Figure 1 shows an X-ray diffraction pattern of the GIT film obtained in Example 2.

EXAMPLES 16 to 19

A study was made also with respect to a system having $Sb_2O_5$ powder or $TeO_2$ powder added. The blend proportions of the powders were as shown in Table 1.

In the same manner as in Example 1, a target was prepared. The density and the resistivity of this sintered body (target) are shown in Table 1.

Under the same conditions as in Example 1, film formation was carried out using a magnetron DC sputtering apparatus. The composition, the resistivity and the transmittance of the film at that time are shown in Table 2.

The film composition in Figure 2 was measured by an ICP method. When the composition of the film was compared with the composition of the target, the contents of $Sb_2O_5$ and $TeO_2$ in the film were found to be smaller.

Identification of the film was carried out by an X-ray diffractometry. All of the films of Examples 16 to 19 were amorphous, with their X-ray diffraction patterns being flat.

EXAMPLES 20 to 26

A study was made also with respect to a system wherein powders of $Y_2O_3$, $La_2O_3$, $CeO_2$, $Pr_6O_{11}$, $Nd_2O_3$, $TiO_2$ and $Nb_2O_5$ were added as a Group 3a element, a Group 4a element and a Group 5a element. The blend proportions of the powders were as shown in Table 1.

In the same manner as in Example 1, a target was prepared. The density and the resistivity of this sintered body (target) are shown in Table 1.

Under the same conditions as in Example 1, film formation was carried out using a magnetron DC sputtering apparatus. The composition, the resistivity and the transmittance of the film at that time, are shown in Table 2.

Identification of the film was crried out by an X-ray diffractometry. All of the films of Examples 20 to 26 were amorphous with their X-ray diffraction patterns being flat.

EXAMPLES 27 and 28

$Ga_2O_3$ powder, $In_2O_3$ powder and $SnO_2$ powder were prepared, and these powders were mixed in the proportions as identified in Table 1 in a dry system ball mill.

In the same manner as in Example 1, a target was prepared. The density and the resistivity of this sintered body (target) are shown in Table 1.

Using a magnetron DC sputtering apparatus, film formation was carried out under the same conditions as in Example 1 (the same conditions as in Example 1 except that the sputtering gas was an Ar-$O_2$ mixed gas, wherein the proportion of oxygen was 3 vol%, since from the preliminary experiments, it was found that the proportion of oxygen was 3 vol% in order to obtain a transparent film having a low electrical resistance). The composition, the resistivity and the transmittance of the transparent conductive film at that time are shown in Table 2.

The resistivities and the transmittances of the respective transparent conductive films thereby obtained are shown in Table 2.

The film composition in Table 2 was measured by an ICP method. The composition of the target and the composition of the GIT film substantially agreed to each other.

EXAMPLE 29

A study was carried out also with respect to an $In_2O_3$-$SnO_2$ powder system. The blend proportions of the powders are as shown in Table 1.

In the same manner as in Example 1, a target was prepared. The density and the resistivity of this sintered body (target) are shown in Table 1.

The target with this composition had high resistance, and DC sputtering was impossible. Therefore, film formation was carried out using a magnetron RF sputtering apparatus. The conditions except for the power source were the same as in Example 27. The resistivity and the transmittance of the film at that time are shown in Table 2. The resistivity was higher than in Examples 1 to 26.

The film composition in Table 2 was measured by an ICP method. The composition of the target and the composition of the GIT film substantially agreed to each other.

Durability test

In order to examine the acid resistance of the obtained transparent conductive films, the films of Examples 1 to 29 were left to stand respectively in a 5 wt% hydrochloric acid aqueous solution at room temperature for 2 hours. As a result, with respect to any one of the films of Examples 1 to 26, no corrosion of the film or no change in the electrical resistance was observed. The same test was carried out with respect to a 5 wt% sulfuric acid aqueous solution, whereby with respect to any one of the films of Examples 1 to 26, no corrosion or no change in the electrical resistance was observed.

With the film of Example 28, in the hydrochloric acid resistance and sulfuric acid resistance tests, the electrical resistance increased 20% and 10%, respectively.

The change in resistance (%) was obtained by the formula:

$$\text{Change in resistance (\%)} = ((\text{resistance after}$$

$$\text{the test}) / (\text{initial resistance})-1)\times 100.$$

Further, in order to examine the alkali resistance, the films of Examples 1 to 29 were left to stand respectively in a 5 wt% sodium hydroxide aqueous solution at 80°C for 30 minutes. As a result, with respect to any one of the membranes of Examples 1 to 26, no corrosion was observed. With respect to any one of the films of Examples 1 to 26, the change in resistance was as small as within from 0 to +5%. With the membrane of Example 27, the resistance increased 45%. With the film of Example 28, the resistance increased 70%.

Further, in order to examine hydrofluoric acid resistance, the films of Examples 1 to 29 were left to stand in a mixed aqueous solution containing 2 wt% of HF+2wt% of nitric acid at room temperature for 30 minutes. As a result, with respect to any one of the films of Examples 1 to 26, no corrosion or no change in resistance was observed. The films of Examples 27 and 28 were entirely dissolved.

Further, in order to examine the moisture resistance, the films of Examples 1 to 29 were left to stand respectively in an atmosphere at a temperature of 40°C with a relative humidity of 90% for 1500 hours. As a result, with respect to any one of the films of Examples 1 to 26, the change in resistance was as small as within $\pm 2\%$. With the film of Example 28, in the moisture resistance, the electrical resistance increased 10%.

Further, in order to examine the resistance against $CF_4$ gas of the transparent conductive films obtained, with respect to each of the films of Examples 1 to 29, an etching test by $CF_4$ gas was carried out using a sputter etching apparatus under such conditions that RF power: 200W, introduced gas: $CF_4$ (20 sccm), pressure: $10^{-2}$ Torr, and treating time: 30 minutes. As a result, each of the films of Examples 1 to 26 showed high resistance against $CF_4$ gas without being etched. Further, the films of Examples 27 and 28 were entirely etched. The film of Example 29 was not etched.

Further, in order to examine the scratch resistance of the transparent conductive films obtained, with respect to each of the films of Examples 1 to 29, test was carried out using a sand eraser (erasing rubber TYPE 48-100, 5 mm in diameter, manufactured by Plus K.K.) under such conditions that load: 500 g, speed: 50 mm/min, number of times: 5 reciprocations. The evaluation was carried out by four ranks of A: no substantial scratching observed, B: hardly scratchable equal to glass, C: scratchable as compared with glass, and D: substantially scratchable. The transparent conductive films of Examples 1 to 19 were evaluated to be rank B, and the transparent conductive films of Examples 20 to 26 were evaluated to be rank A and found to show high scratch resistance. The films of Examples 27 and 28 were evaluated to be rank C. The film of Example 29 was evaluated to be rank D.

These results are shown in Table 2.

EXAMPLE 30

The GIT film obtained in Example 2 was subjected to heat treatment in air at 250°C for 30 minutes. As a result, the resistivity decreased to $1.8\times 10^{-3}$ $\Omega$cm. The visible light transmittance was 82% without change. Further, also with respect to the GIT film obtained in Example 2, heat treatment was carried out in $N_2$ at 500°C for 30 minutes. As a result, the resistivity decreased to $1.3\times 10^{-3}$ $\Omega$cm. The visible light transmittance was 82% without change.

EXAMPLE 31

A GIT film was formed in the same manner as in Example 2 except that the geometrical film thickness of the GIT film was changed to 150 nm.

Then, an electrode and an electrode terminal portion were printed by a screen printing method on the GIT film and baked at 300°C. Then, a lead wire was soldered to the electrode terminal portion.

Then, a glass substrate having the same size was prepared, and this glass substrate and the above-mentioned glass substrate having the GIT film formed were sealed by a sealant with a spacer interposed therebetween to obtain a double layer glass.

The visible light transmittance of the double layer glass thus prepared was 80%. The color tone was neutral. The resistance between the bus bar electrodes was measured by lead wires taken out by passing through the sealant, and found to be 135 $\Omega$. A voltage of 32 V was applied across the bus bars to conduct the current conducting test, whereby even after expiration of 6 weeks, the resistance and the outer appearance were constant without change. As described above, the double layer glass was one which excellently functioned as an electrically heated glass.

According to the present invention, a tin oxide type transparent conductive film excellent in chemical resistance can be obtained.

Further, the transparent conductive film obtained by the present invention is amorphous and accordingly smooth without surface irregularities, and it is excellent in scratch resistance and has electrical conductivity. Accordingly, when used as an overcoat of an insulated article, it provides an effect as a highly durable antistatic film. Particularly, a transparent film can be obtained even without heating the substrate, and it can be utilized as an antistatic film having also a function of a protective film, for e.g. a plastic film.

Further, the target of the present invention is electrically conductive and useful for DC sputtering whereby the film forming speed is high. Yet, the target is highly dense, and sputtering can be carried out under stabilized electrical discharge.

## Claims

1. A Substrate coated with a transparent conductive film of tin oxide type containing gallium and indium, which contains, when gallium is calculated as $Ga_2O_3$, indium is calculated as $In_2O_3$ and tin is calculated as $SnO_2$, gallium in an amount of from 0.1 to 30 mol% as calculated as $Ga_2O_3$ and indium in an amount of from 0.1 to 30 mol% as calculated as $In_2O_3$, based on the total amount of $Ga_2O_3$, $In_2O_3$ and $SnO_2$.

2. The Substrate coated with a transparent conductive film according to Claim 1, wherein the content of gallium is from 1 to 15 mol% as calculated as $Ga_2O_3$, and the content of indium is from 1 to 15 mol% as calculated as $In_2O_3$.

3. The Substrate coated with a transparent conductive film according to Claim 1, which contains antimony and/or tellurium.

4. The Substrate coated with a transparent conductive film according to Claim 1, which contains at least one metal selected from the group consisting of Group 3 (inclusive of lanthanoids and not inclusive of actinoids), Group 4 and Group 5 of the long-form Periodic Table.

5. A sputtering target of tin oxide type containing gallium and indium, which contains, when gallium is calculated as $Ga_2O_3$, indium is calculated as $In_2O_3$ and tin is calculated as $SnO_2$, gallium in an amount of from 0.1 to 30 mol% as calculated as $Ga_2O_3$ and indium in an amount of from 0.1 to 30 mol% as calculated as $In_2O_3$, based on the total amount of $Ga_2O_3$, $In_2O_3$ and $SnO_2$.

6. The sputtering target according to Claim 5, wherein the content of gallium is from 1 to 15 mol% as calculated as $Ga_2O_3$, and the content of indium is from 1 to 15 mol% as calculated as $In_2O_3$.

7. The sputtering target according to Claim 5, which contains antimony and/or tellurium.

8. The sputtering target according to Claim 5, which contains at least one metal selected from the group consisting of Group 3 (inclusive of lanthanoids and not inclusive of actinoids), Group 4 and Group 5 of the long-form Periodic Table.

**Patentansprüche**

1. Substrat, welches mit einem transparenten, leitfähigen Film einer Gallium und Indium enthaltenden Zinnoxidart beschichtet ist, welcher, wenn Gallium als $Ga_2O_3$ berechnet ist, Indium als $In_2O_3$ berechnet ist und Zinn als $SnO_2$ berechnet ist, Gallium in einer Menge von 0,1 bis 30 Mol-%, als $Ga_2O_3$ berechnet, und Indium in einer Menge von 0,1 bis 30 Mol-%, als $In_2O_3$ berechnet, basierend auf der Gesamtmenge von $Ga_2O_3$, $In_2O_3$ und $SnO_2$, enthält.

2. Substrat, welches mit einem transparenten, leitfähigen Film beschichtet ist, gemäß Anspruch 1, wobei der Anteil von Gallium von 1 bis 15 Mol-%, als $Ga_2O_3$ berechnet, ist, und der Anteil von Indium von 1 bis 15 Mol-%, als $In_2O_3$ berechnet, ist.

3. Substrat, welches mit einem transparenten, leitfähigen Film beschichtet ist, gemäß Anspruch 1, welcher Antimon und/oder Tellur enthält.

4. Substrat, welches mit einem transparenten, leitfähigen Film beschichtet ist, gemäß Anspruch 1, welcher mindestens ein Metall, ausgewählt aus der Gruppe, bestehend aus Gruppe 3 (einschließlich der Lanthanoide und nicht einschließlich der Actinoide), Gruppe 4 und Gruppe 5 der langen Ausführungsform des Periodensystems, enthält.

5. Sputtertarget einer Gallium und Indium enthaltenden Zinnoxidart, welches, wenn Gallium als $Ga_2O_3$ berechnet ist, Indium als $In_2O_3$ berechnet ist und Zinn als $SnO_2$ berechnet ist, Gallium in einer Menge von 0,1 bis 30 Mol-%, als $Ga_2O_3$ berechnet, und Indium in einer Menge von 0,1 bis 30 Mol-%, als $In_2O_3$ berechnet, basierend auf der Gesamtmenge von $Ga_2O_3$, $In_2O_3$ und $SnO_2$, enthält.

6. Sputtertarget nach Anspruch 5, wobei der Anteil von Gallium von 1 bis 15 Mol-%, als $Ga_2O_3$ berechnet, ist, und der Anteil von Indium von 1 bis 15 Mol-%, als $In_2O_3$ berechnet, ist.

7. Sputtertarget nach Anspruch 5, welches Antimon und/oder Tellur enthält.

8. Sputtertarget nach Anspruch 5, welches mindestens ein Metall, ausgewählt aus der Gruppe, bestehend aus Gruppe 3 (einschließlich der Lanthanoide und nicht einschließlich der Actinoide), Gruppe 4 und Gruppe 5 der langen Ausführungsform des Periodensystems, enthält.

**Revendications**

1. Substrat revêtu d'un film conducteur transparent du type oxyde d'étain contenant du gallium et de l'indium, et qui contient, lorsque le gallium est calculé en $Ga_2O_3$, l'indium en $In_2O_3$ et l'étain en $SnO_2$, du gallium en une quantité de 0,1 à 30 % en moles calculés en $Ga_2O_3$ et de l'indium en une quantité de 0,1 à 30 % en moles calculés en $In_2O_3$, sur la base de la quantité totale de $Ga_2O_3$, de $In_2O_3$ et de $SnO_2$.

2. Substrat revêtu d'un film conducteur transparent selon la revendication 1, dont la teneur en gallium est de 1 à 15 % en moles calculés en $Ga_2O_3$, et la teneur en indium est de 1 à 15 % en moles calculés en $In_2O_3$.

3. Substrat revêtu d'un film conducteur transparent selon la revendication 1 contenant de l'antimoine et/ou du tellure.

4. Substrat revêtu d'un film conducteur transparent selon la revendication 1 contenant au moins un métal sélectionné parmi les Groupes 3 (y compris les lanthanoïdes et non compris les actinoïdes), 4 et 5 du tableau périodique long.

5. Cible pour pulvérisation cathodique du type oxyde d'étain contenant du gallium et de l'indium, qui contient, lorsque le gallium est calculé en $Ga_2O_3$, l'indium en $In_2O_3$ et l'étain en $SnO_2$, du gallium en une quantité de 0,1 à 30 % en moles calculés en $Ga_2O_3$ et de l'indium en une quantité de 0,1 à 30 % en moles calculés en $In_2O_3$, sur la base de la quantité totale de $Ga_2O_3$, calculés en $In_2O_3$ et de $SnO_2$.

6. Cible pour pulvérisation cathodique selon la revendication 5, dont la teneur en gallium est de 1 à 15 % en moles calculés en $Ga_2O_3$ et la teneur en indium est de 1 à 15 % en moles calculés en $In_2O_3$.

7. Cible pour pulvérisation cathodique selon la revendication 5, contenant de l'antimoine et/ou du tellure.

8. Cible pour pulvérisation cathodique selon la revendication 5, contenant au moins un métal sélectionné parmi les Groupes 3 (y compris les lanthanoïdes, non compris les actinoïdes), 4 et 5 du tableau périodique long.

# FIG. 1